# EUROPEAN PATENT APPLICATION

(11) **EP 4 317 524 A1**
(43) Date of publication of application: **07.02.2024**
(21) Application number: 22188090.9
(22) Date of filing: 01.08.2022
(51) Int. Cl.: C23C 14/32, C23C 14/16, C23C 14/18, C23C 14/20, H01J 37/32

(54) **CATHODIC ARC EVAPORATION APPARATUS AND METHOD FOR COATING AT LEAST ONE SUBSTRATE**

(71) Applicant: Platit AG, 2545 Selzach (CH)
(72) Inventor: JILEK Sr., Mojmir, 78701 Sumperk (CZ); ZEMLICKA, Radek, 2545 Selzach (CH); LÜMKEMANN, Andreas, 3294 Büren a. A. (CH); UCIK, Martin, 78501 Sternberk (CZ)
(74) Representative: Winter, Brandl - Partnerschaft mbB

(57) **Abstract**

The present disclosure is directed to a cathodic arc evaporation apparatus (2) for coating at least one substrate (6), comprising a vacuum chamber (4) in which a physical vapour deposition can be carried out; at least one substrate (6) to be coated being arranged in the vacuum chamber (4); and a bias voltage supply (40) for powering the at least one substrate (6) being configured to be operated in pulsed mode; wherein a pulsed first cathode arc discharge (16) and a pulsed second cathode arc discharge (26) are time-shifted relative to each other and are in synchronization with a pulsed bias voltage (42).

## Description

The present disclosure is directed to a cathodic arc evaporation apparatus and method for coating at least one substrate.

In the manufacture of items which require thin (e.g. 0.01 µm to 20 µm) films for mechanical, optical, chemical or electronic functions, in particular for providing a hard and wear resistant protective coating, physical vapor deposition (PVD) or chemical vapor deposition (CVD) are common technologies. These deposition methods involve ejecting material from a "cathode/target" onto a "substrate". In detail, material is vaporized from the cathode by a high-power electric arc, by heat or by high-energy particles. The vaporized material then condenses on the substrate, forming a thin film on the substrate.

Among those PVD methods, cathodic arc evaporation and magnetron sputtering are two of the most commonly used.

In case of low-pressure cathodic arc evaporation deposition (hereinafter referred to only as cathodic arc evaporation deposition), the cathode vaporizes and emits ions from the cathode surface in addition to electrons due to high temperature of so-called cathode spot. These particles, in particular, the ions, land on the substrate where they form a layer. A so-called bias voltage can be applied to the substrate to provide an adjustable amount of energy to the ions on impact. Thus, the bias voltage can influence the physics of material condensation and crystal structure formation.

In case of (direct current (DC)) magnetron sputtering, only neutral metal atoms are sputtered and can be transported from the cathode to the substrate. These neutral atoms cannot be supplied with energy by using of the bias voltage on the substrate and the growing layer is usually less compact. Thus, the cathodic arc evaporation has advantages over DC magnetron sputtering regarding the growth of more compact and resistant layers when condensed on the substrate, due to the high ionization of the emitted metallic particles.

However, in case of magnetron sputtering, it is possible to achieve metal ionization by using high power impulse magnetron sputtering (HiPIMS) technology. HiPIMS utilises extremely high power densities in short pulses (impulses) at low duty cycle. A distinguishing feature of HiPIMS is a high degree of ionization of the sputtered metal, which results in high density of deposited films. In this connection, the pulses at the sputtered cathode can be synchronized with the pulses of the bias voltage in order to supply different energy to the ions cathodes of different material. Thus, by choosing different energies for different types of atoms in the deposited layer, the mechanical properties of the layer, e.g. hardness and tensile stress, can be influenced. Anyhow, the cathodic arc evaporation has advantages over HiPIMS regarding the high deposition rates, the robustness and acquisition costs.

In view of the above, the object of the present invention is to provide a cathodic arc evaporation apparatus and method, which allows influencing the mechanical properties of the deposited layer while maintaining high deposition rates, high ionization, high robustness and low costs.

This object is solved by a cathodic arc evaporation apparatus and a cathodic arc evaporation method as defined in the independent claims.

According to an aspect of the present disclosure a cathodic arc evaporation apparatus for coating at least one substrate, comprises a vacuum chamber in which a physical vapor deposition can be carried out.

The vacuum chamber comprises at least one anode. For example, the at least one anode (e.g. a first anode and/or a second anode and/or a third anode) of the vacuum chamber can be formed by a (grounded) wall of the vacuum chamber or a discrete anode. In particular, the (grounded) wall or the discrete anode can be a common anode for several cathodes. In other words, it is not necessary to have a special/separate anode for each cathode.

Further, the vacuum chamber comprises a first cathode, the first cathode being made of a first material, and a first arc power supply for powering the first cathode, the first arc power supply being configured to be operated in pulsed mode. The vacuum chamber is configured to ignite an arc between the at least one anode (that is, a first anode or the common anode) and the first cathode by a pulsed first cathode arc discharge.

Further, the vacuum chamber comprises a second cathode, the second cathode being made of a second material being different than the first material, and a second arc power supply for powering the second cathode, the second arc power supply being configured to be operated in pulsed mode. The vacuum chamber being configured to ignite an arc between the at least one anode (that is, a second anode or the common anode) and the second cathode by a pulsed second cathode arc discharge.

That is, the vacuum chamber comprises at least two cathodes being powered by separate arc power supplies in pulsed mode and being made from different materials in order to form a layer of the two materials on the substrate to be coated.

Moreover, the cathodic arc evaporation apparatus comprises at least one substrate to be coated being arranged in/within the vacuum chamber. The substrate may have any geometry or shape including complex 3D surfaces.

Further, the cathodic arc evaporation apparatus comprises a bias voltage supply for powering the at least one substrate being configured to be operated in pulsed mode. That is, the at least one substrate can be applied with the bias voltage in order to adjust the speed and thus, the amount of energy to the ions on impact.

According to the aspect of the present disclosure, the cathodic arc evaporation apparatus is configured in such a way that the pulsed first cathode arc discharge and the pulsed second cathode arc discharge are time-shifted/have a delay relative to each other and are in synchronization with a pulsed bias voltage. Synchronization means that the pulsed first cathode arc discharge and the pulsed second cathode arc discharge are adjusted to the pulsed bias voltage and not necessarily that the pulse curve is exactly the same. That is, each of the many pulses of the first/second cathode occurs at the same time/at the same level of the pulsed bias voltage and it does not vary from pulse to pulse of the first/second cathode. Hence, since the pulsed first cathode arc discharge and the pulsed second cathode arc discharge are time-shifted, i.e. do not have their pulses (their maximum) at the same time, there is a different pulsed bias voltage at the time of the pulse of the first cathode than at the time of the pulse of the second cathode. Thus, the ions of the first cathode have a different energy than the ions of the second cathode.

By synchronizing the pulsed first/second cathode arc discharge with the pulsed bias voltage, it is possible to provide a cathodic arc deposition technology which is applicable to industrial applications and which offers the possibility to select different energies for different ions species incident on a substrate form different cathodes.

Further, preferably the cathodes may be rotating cylindrical (elemental) cathodes. Thus, the cathodes can be arranged close to each other in order to enable mixing of the elements of the cathodes prior to condensation.

The cathodic arc evaporation apparatus may be configured in such a way that the pulsed bias voltage is different during the pulsed first cathode arc discharge and the pulsed second cathode arc discharge. For example, the pulsed bias voltage may be lower during the pulsed first cathode arc discharge than during the pulsed second cathode arc discharge. Alternatively, the pulsed bias voltage may be higher during the pulsed first cathode arc discharge than during the pulsed second cathode arc discharge. This allows the layer to be optimized.

The cathodic arc evaporation apparatus may be configured in such a way that a maximum amplitude/peak of the pulsed bias voltage is at least partially overlapping with a maximum amplitude/peak of the pulsed first cathode arc discharge and/or the pulsed second cathode arc discharge. This allows the high energy (during the pulsed bias voltage) to be used efficiently.

The cathodic arc evaporation apparatus may be configured in such a way that the maximum amplitude/peak of the pulsed bias voltage takes place at the same time as the maximum amplitude/peak of the pulsed first cathode arc discharge or the pulsed second cathode arc discharge. This means that they have to follow the same course (of highs and lows) in order to exploit the pulsed bias voltage as well as possible.

The cathodic arc evaporation apparatus may be configured in such a way that an amplitude of the pulsed bias voltage being lower than the maximum amplitude/peak of the pulsed bias voltage takes place at the same time as the maximum amplitude/peak of the pulsed first cathode arc discharge or the pulsed second cathode arc discharge. This means that between the individual pulses of the pulsed bias voltage it is not necessary to completely switch off the bias voltage during the off-time. Nor is it necessary to completely switch off the pulsed first cathode arc discharge or the pulsed second cathode arc discharge during the off-time. Hence, during the respective off-time, the first/pulsed second cathode arc discharge can produce a low current and the pulsed bias voltage can produce a low voltage.

The cathodic arc evaporation apparatus may be configured in such a way that a duration of the maximum amplitude/peak of the pulsed first cathode arc discharge is different to a duration the maximum amplitude/peak of the pulsed second cathode arc discharge. By the selective-ion-species irradiation, desired properties can be set.

The cathodic arc evaporation apparatus may be configured in such a way that a pulse frequency of the pulsed first cathode arc discharge, the pulsed second cathode arc discharge and/or the pulsed bias voltage are/is lower than 50 Hz, preferably lower than 20 Hz, for example about 10 Hz. That is, a low pulse frequency is used. This has the advantage that using the low pulse frequency a simpler and cheaper technology can be used in comparison to a high pulse frequency operating at frequencies of tens and hundreds of kHz.

The at least one substrate and/or the first and second cathodes may be rotatable with a predetermined rotational speed. Thus, coating of complex surfaces and substrates is possible. Further, the simultaneous coating of several substrates is possible.

The cathodic arc evaporation apparatus may be configured in such a way that the pulse frequency is set in accordance with the predetermined rotational speed. Hence, it is ensured that the pulse frequency is sufficient to avoid forming of undesirable multilayers on a relatively slowly moving substrate when the pulses are out of synchronization or shifted relative to each other.

The vacuum chamber may comprise a third cathode, the third cathode being made of a third material being different than the first material and the second material, and a third arc power supply for powering the third cathode, the third arc power supply being configured to be operated in pulsed mode, the vacuum chamber being configured to ignite an arc between the at least one anode (that is, a third anode or the common anode) and third first cathode by a third cathode pulsed arc discharge. The vacuum chamber may comprise more than three cathodes and arc power supplies, for example four, five, six or more cathodes and arc power supplies.

Further, the cathodic arc evaporation apparatus may be configured in such a way that the pulsed first cathode arc discharge, the pulsed second cathode arc discharge and the third cathode pulsed arc discharge are time-shifted/have a delay and are in synchronization with the pulsed bias voltage. Thus, the substrate can be coated with several different materials, each of whose mechanical properties has been influenced.

### Brief Description of the Drawings

Fig. 1 is a schematic illustration of a cathodic arc evaporation apparatus; and
Fig. 2 is a graph showing a cathodic arc evaporation method in form of an exemplary curve/course of a pulsed bias voltage as well as a pulsed first cathode arc discharge, a pulsed second cathode arc discharge and a third cathode pulsed arc discharge.

### Detailed Description of the Embodiments

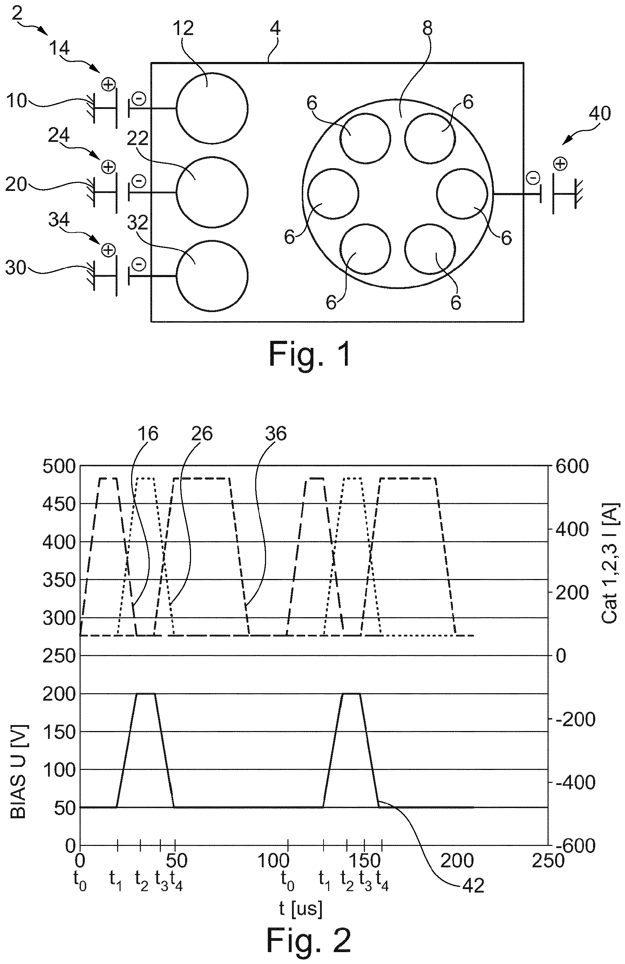

Fig. 1 shows a (low-pressure) cathodic arc evaporation apparatus 2. The cathodic arc evaporation apparatus 2 comprises a vacuum chamber 4 in which a physical vapour deposition can be carried out. Further, the cathodic arc evaporation apparatus 2 comprises at least one substrate 6 to be coated. The at least one substrate 6 is arranged in the vacuum chamber 4.

In the embodiment shown, the at least one substrate 6, in particular several substrates 6, is/are held/received by substrate holding means. Preferably, the substrate holding means may be in the form of a carousel holder 8 holding the at least one substrate/the several substrates 6 at a predetermined position within the vacuum chamber 4. The carousel holder 8 is enabled to rotate the at least one substrate/the several substrates 6 around one or more axes, for example around a respective longitudinal axis of each of the substrates 6 and/or around a longitudinal axis of the carousel holder 8.

The vacuum chamber 4 comprises a first anode 10, a first cathode 12 and a first arc power supply 14 for powering the first cathode 12. The first anode 10 may be formed by a (grounded) wall of the vacuum chamber 4. Alternatively, the first anode 10 may be formed by a discrete anode, even though not shown in the Figures. The first cathode 12 is made of a first material. That is, the first cathode 12 is an elemental cathode. For example, the first material may be Titanium. The first arc power supply 14 is configured to be operated in pulsed mode. Thus, the vacuum chamber 4 is configured to ignite an arc between the first anode 10 and the first cathode 12 by a pulsed first cathode arc discharge 16 (see Fig. 2).

The vacuum chamber 4 comprises a second anode 20, a second cathode 22 and a second arc power supply 24 for powering the second cathode 22. The second anode 20 may be formed by a (grounded) wall of the vacuum chamber 4. That is, the first anode 10 and the second anode 20 can be formed by a common anode. Alternatively, the second anode 20 may be formed by a discrete anode, even though not shown in the Figures. The second cathode 22 is made of a second material. That is, the second cathode 22 is an elemental cathode. For example, the second material may be Aluminum. The second arc power supply 24 is configured to be operated in pulsed mode. Thus, the vacuum chamber 4 is configured to ignite an arc between the second anode 20 and the second cathode 22 by a pulsed second cathode arc discharge 26 (see Fig. 2).

In the embodiment shown, the vacuum chamber 4 comprises a third anode 30, a third cathode 32 and a third arc power supply 34 for powering the third cathode 32. Alternatively, the vacuum chamber 4 may only have two anodes, cathodes and arc power supplies or more than three anodes, cathodes and arc power supplies, such as four five, six, seven or eight, even though not shown in the Figures. The third anode 30 may be formed by a (grounded) wall of the vacuum chamber 4. That is, the first anode 10, the second anode 20 and the third anode 30 can be formed by a common anode. Alternatively, the third anode 30 may be formed by a discrete anode, even though not shown in the Figures. The third cathode 32 is made of a third material. That is, the third cathode 32 is an elemental cathode. For example, the third material may be Chromium. The third arc power supply 24 is configured to be operated in pulsed mode. Thus, the vacuum chamber 4 is configured to ignite an arc between the third anode 30 and the third cathode 32 by a pulsed third cathode arc discharge 36 (see Fig. 2).

The cathodes 12, 22, 32 are arranged closed to each other. Thus, the materials of the cathodes 12, 22, 32 are enabled to mix with each other prior to condensation on the at least one substrate 6. In particular, a distance between two adjacent cathodes 12, 22, 32, that is, a distance between the first cathode 12 and the second cathode 22 and/or a distance between the second cathode 22 and the third cathode 32, may be less than a diameter of the cathodes 12, 22, 32, preferably less than a radius of the cathodes 12, 22, 32. In other words, the distance between the longitudinal axes of two adjacent cathodes 12, 22, 32 may be less than 2-times the diameter of the cathodes 12, 22, 32, preferably less than 1.5-times the diameter of the cathodes 12, 22, 32.

Further, the cathodic arc evaporation apparatus 2 comprises a bias voltage supply 40 for powering the at least one substrate 6. The bias voltage supply 40 is configured to be operated in pulsed mode. Thus, the vacuum chamber 4 is configured to be operated by a pulsed bias voltage 42 (see Fig. 2).

In the following, an operation of the cathodic arc evaporation apparatus 2/a cathodic arc evaporation method according to the present disclosure is described using an exemplary curve/course of the pulsed bias voltage 42 as well as the pulsed first cathode arc discharge 16, the pulsed second cathode arc discharge 26 and the third cathode pulsed arc discharge 36 as shown in Fig. 2.

Fig. 2 is a graph illustrating in a lower area the course of the pulsed bias voltage 42 over time having the time [us] plotted on the abscissa/x-axis and the bias voltage [V] plotted on the (left) ordinate/y-axis, and in a upper are the course of the pulsed first cathode arc discharge 16, the pulsed second cathode arc discharge 26 and the third cathode pulsed arc discharge 36 over time having the time [us] plotted on the abscissa/x-axis and the respective cathode current [A] plotted on the (right) ordinate/y-axis.

Within a pulse period of the pulsed bias voltage 42, at a starting point in time to, the course of the pulsed bias voltage 42 has a base voltage level, for example 50 V as in the graph. At a first point in time t₁, the course of the pulsed bias voltage 42 has the base voltage level and starts to increase, for example linearly as in the graph. At a second point in time t₂, the course of the pulsed bias voltage 42 reaches a pulsed voltage level, for example 200 V as in the graph. At a third point in time t₃, the course of the pulsed bias voltage 42 has the pulsed voltage level and starts to decrease, for example linearly as in the graph. At a fourth point in time t₄, the course of the pulsed bias voltage 42 reaches the base voltage level. The pulse period of the pulse bias voltage 42 repeats itself.

Within a pulse period of the pulsed first cathode arc discharge 16, at the starting point in time t₀, the course of the pulsed first cathode arc discharge 16 has a base first cathode current level, for example 275 A as in the graph, and starts to increase, for example linearly as in the graph. Before the first point in time t₁, the course of the pulsed first cathode arc discharge 16 reaches a pulsed first cathode current level, for example 480 A as in the graph. At the first point in time t₁, the course of the pulsed first cathode arc discharge 16 has the pulsed first cathode current level and starts to decrease, for example linearly as in the graph. At the second point in time t₂, the course of the pulsed first cathode arc discharge 16 reaches the base first cathode current level. At the third point in time t₃ and at the fourth point in time t₄, the course of the pulsed first cathode arc discharge 16 has the base first cathode current level. The pulse period of the pulsed first cathode arc discharge 16 repeats itself.

Within a pulse period of the pulsed second cathode arc discharge 26, at the starting point in time t₀, the course of the pulsed second cathode arc discharge 26 has a base second cathode current level, for example 275 A as in the graph. At the first point in time t₁, the course of the pulsed second cathode arc discharge 26 has the base second cathode current level and starts to increase, for example linearly as in the graph. At the second point in time t₂, the course of the pulsed second cathode arc discharge 26 reaches a pulsed second cathode current level, for example 480 A as in the graph. At the third point in time t₃, the course of the pulsed second cathode arc discharge 26 has the pulsed second cathode current level and starts to decrease, for example linearly as in the graph. At the fourth point in time t₄, the course of the pulsed second cathode arc discharge 26 reaches the base second cathode current level. The pulse period of the pulsed second cathode arc discharge 26 repeats itself.

Within a pulse period of the pulsed third cathode arc discharge 26, at the starting point in time t₀, at the first point in time t₁ and at the second point in time t₂, the course of the pulsed third cathode arc discharge 36 has a base third cathode current level, for example 275 A as in the graph. At the third point in time t₃, the course of the pulsed third cathode arc discharge 36 has the base third cathode current level and starts to increase, for example linearly as in the graph. At the fourth point in time t₄, the course of the pulsed third cathode arc discharge 36 reaches a pulsed third cathode current level, for example 480 A as in the graph. After the fourth point in time t₄, the course of the pulsed third cathode arc discharge 36 has the pulsed third cathode current level and starts to decrease, for example linearly as in the graph. Before the starting point in time to of the next pulse period of the pulsed bias voltage 42, the course of the pulsed third cathode arc discharge 36 reaches the base third cathode current level. The pulse period of the pulsed third cathode arc discharge 36 repeats itself.

According to the present disclosure, the cathodic arc evaporation apparatus 2 is configured in such a way that the pulsed first cathode arc discharge 16 and the pulsed second cathode arc discharge 26 (and the third cathode arc discharge 36) are time-shifted relative to each other. In other words, the pulsed first cathode arc discharge 16 and the pulsed second cathode arc discharge 26 (and the third cathode arc discharge 36) have a delay relative to each other. Further, the cathodic arc evaporation apparatus 2 is configured in such a way that the pulsed first cathode arc discharge 16 and the pulsed second cathode arc discharge 26 (and the third cathode arc discharge 36) are in synchronization with the pulsed bias voltage 42.

As can be seen in Fig. 2, synchronization means that within every pulse period the base (first/second/third) cathode current level and the pulsed (first/second/third) cathode current level take place at the same time/timing of the course of the pulsed bias voltage 42. In other words, there is no variation from pulse to pulse/from pulse period to pulse period of the respective cathodes 12, 22, 32. Hence, since the pulsed first cathode arc discharge 16 and the pulsed second cathode arc discharge 26 (and the pulsed third cathode arc discharge 36) are time-shifted, i.e. do not have their pulses (their maximum/their pulsed (first/second/third) cathode current levels) at the same time, there is a different level of the pulsed bias voltage at the time of the pulse of the first cathode 12 than at the time of the pulse of the second cathode 22 (and at the time of the pulse of the third cathode). Thus, the ions of the first cathode 12 have a different energy than the ions of the second cathode 22 (and the ions of the third cathode 32).

In particular, the cathodic arc evaporation apparatus 2 may be configured in such a way that the pulsed bias voltage 42 is different during the pulsed first cathode arc discharge 16 and the pulsed second cathode arc discharge 26 (and the pulsed third cathode arc discharge 36). In the exemplary course of Fig. 2, the pulsed bias voltage 42 is lower during the pulsed first cathode arc discharge 16 (and during the pulsed third cathode arc discharge 36) than during the pulsed second cathode arc discharge 26.

Further, the cathodic arc evaporation apparatus 2 may be configured in such a way that a maximum amplitude/peak/pulsed voltage level of the pulsed bias voltage 42 is at least partially overlapping with, preferably takes place at the same time as, a maximum amplitude/peak/pulsed (first/second/third) cathode current level of the pulsed first cathode arc discharge 16 and/or the pulsed second cathode arc discharge 26 (and/or the pulsed third cathode arc discharge 36). In the exemplary course of Fig. 2, the maximum amplitude/peak/pulsed voltage level of the pulsed bias voltage 42 exactly takes place at the same time as the maximum amplitude/peak/pulsed second cathode current level of the pulsed second cathode arc discharge 26.

Further, the cathodic arc evaporation apparatus 2 may be configured in such a way that a duration of the maximum amplitude/peak/pulsed first cathode current level of the pulsed first cathode arc discharge 16 is different to a duration the maximum amplitude/peak/pulsed second cathode current level of the pulsed second cathode arc discharge 26 (and/or a duration the maximum amplitude/peak/pulsed third cathode current level of the pulsed third cathode arc discharge 36). In the exemplary course of Fig. 2, the duration of the maximum amplitude/peak/pulsed first cathode current level of the pulsed first cathode arc discharge 16 is substantially the same as the duration the maximum amplitude/peak/pulsed second cathode current level of the pulsed second cathode arc discharge 26 and shorter than the duration the maximum amplitude/peak/pulsed third cathode current level of the pulsed third cathode arc discharge 36.

Moreover, the cathodic arc evaporation apparatus 2 may be configured in such a way that a pulse frequency of the pulsed first cathode arc discharge 16, the pulsed second cathode arc discharge 26 (and the third cathode arc discharge 36) and/or the pulsed bias voltage are/is lower than 50 Hz, preferably lower than 20 Hz, for example about 10 Hz. That is, a low pulse frequency is used.

As described above, the at least one substrate 6 may be rotatable with a predetermined substrate rotational speed. Further, the first cathode 12, the second cathode 22 and/or the third cathode 32 may be rotatable with a predetermined cathode rotational speed. Preferably, the cathodic arc evaporation apparatus 2 may be configured in such a way that the pulse frequency is set in accordance with the predetermined substrate/cathode rotational speed.

## Claims

1. A cathodic arc evaporation apparatus (2) for coating at least one substrate (6), comprising:
a vacuum chamber (4) in which a physical vapour deposition can be carried out; the vacuum chamber (4) comprising
at least one anode (10, 20, 30);
a first cathode (12), the first cathode (12) being made of a first material;
a first arc power supply (14) for powering the first cathode (12), the first arc power supply (14) being configured to be operated in pulsed mode, the vacuum chamber (4) being configured to ignite an arc between the at least one anode (10, 20, 30) and the first cathode (12) by a pulsed first cathode arc discharge (16);
a second cathode (22), the second cathode (22) being made of a second material being different to the first material;
a second arc power supply (24) for powering the second cathode (22), the second arc power supply (24) being configured to be operated in pulsed mode, the vacuum chamber (4) being configured to ignite an arc between the at least one anode (10, 20, 30) and the second cathode (22) by a pulsed second cathode arc discharge (26);
at least one substrate (6) to be coated being arranged in the vacuum chamber (4); and
a bias voltage supply (40) for powering the at least one substrate (6), the bias voltage supply (40) being configured to be operated in pulsed mode;
**characterized in that**
the pulsed first cathode arc discharge (16) and the pulsed second cathode arc discharge (26) are time-shifted relative to each other and are in synchronization with a pulsed bias voltage (42).

2. The cathodic arc evaporation apparatus (2) according to claim 1,
wherein the cathodic arc evaporation apparatus (2) is configured in such a way that the pulsed bias voltage (42) is different during the pulsed first cathode arc discharge (16) and the pulsed second cathode arc discharge (26).

3. The cathodic arc evaporation apparatus (2) according to claim 2,
wherein the cathodic arc evaporation apparatus (2) is configured in such a way that a maximum amplitude/peak of the pulsed bias voltage (42) is at least partially overlapping with a maximum amplitude/peak of the pulsed first cathode arc discharge (16) and/or the pulsed second cathode arc discharge (26).

4. The cathodic arc evaporation apparatus (2) according to claim 3,
wherein the cathodic arc evaporation apparatus (2) is configured in such a way that the maximum amplitude/peak of the pulsed bias voltage (42) takes place at the same time as the maximum amplitude/peak of the pulsed first cathode arc discharge (16) or the pulsed second cathode arc discharge (26).

5. The cathodic arc evaporation apparatus (2) according to claim 3 or 4,
wherein the cathodic arc evaporation apparatus (2) is configured in such a way that an amplitude of the pulsed bias voltage (42) being lower than the maximum amplitude/peak of the pulsed bias voltage (42) takes place at the same time as the maximum amplitude/peak of the pulsed first cathode arc discharge (16) or the pulsed second cathode arc discharge (26).

6. The cathodic arc evaporation apparatus (2) according to any one of claims 3 to 5, wherein the cathodic arc evaporation apparatus (2) is configured in such a way that a duration of the maximum amplitude/peak of the pulsed first cathode arc discharge (16) is different to a duration the maximum amplitude/peak of the pulsed second cathode arc discharge (26).

7. The cathodic arc evaporation apparatus (2) according to any one of claims 1 to 6, wherein the cathodic arc evaporation apparatus (2) is configured in such a way that a pulse frequency of the pulsed first cathode arc discharge (16), the pulsed second cathode arc discharge (26) and/or the pulsed bias voltage (42) are/is lower than 50 Hz, preferably lower than 20 Hz, for example about 10 Hz.

8. The cathodic arc evaporation apparatus (2) according to claim 7,
wherein the at least one substrate (6) and/or the first and second cathodes (12, 22) is/are rotatable with a predetermined rotational speed,
wherein the cathodic arc evaporation apparatus (2) is configured in such a way that the pulse frequency is set in accordance with the predetermined rotational speed.

9. The cathodic arc evaporation apparatus according to any one of claims 1 to 8, wherein the vacuum chamber (4) comprises a third cathode (32), the third cathode (32) being made of a third material being different than the first material and the second material, and a third arc power supply (34) for powering the third cathode (32), the third arc power supply (34) being configured to be operated in pulsed mode, the vacuum chamber (4) being configured to ignite an arc between the at least one anode (10, 20, 30) and third cathode (32) by a third cathode pulsed arc discharge (36),
wherein the cathodic arc evaporation apparatus (2) is configured in such a way that the pulsed first cathode arc discharge (16), the pulsed second cathode arc discharge (26) and the third cathode pulsed arc discharge (36) are time-shifted relative to each other and are in synchronization with the pulsed bias voltage (42).

10. A cathodic arc evaporation method for coating at least one substrate (6) in a vacuum chamber (4) comprising at least one anode (10, 20, 30), a first cathode (12), a second anode (20) and a second cathode (22), the first cathode (12) being made of a first material and the second cathode (22) being made of a second material different to the first material, the method comprising:
powering the first cathode (12) in a pulsed mode and igniting an arc between the at least one anode (10, 20, 30) and the first cathode (12) by a pulsed first cathode arc discharge (16),
powering the second cathode (22) in a pulsed mode and igniting an arc between the at least one anode (10, 20, 30) and the second cathode (22) by a pulsed second cathode arc discharge (26), and
powering the at least one substrate (6) in a pulsed mode,
**characterized in that**
the pulsed first cathode arc discharge (16) and the pulsed second cathode arc discharge (26) are time-shifted relative to each other and are in synchronization with a pulsed bias voltage (42).

## Amended claims

### Amended claims in accordance with Rule 137(2) EPC.

1. A cathodic arc evaporation apparatus (2) for coating at least one substrate (6), comprising:
a vacuum chamber (4) in which a physical vapour deposition can be carried out;
the vacuum chamber (4) comprising
at least one anode (10, 20, 30);
a first cathode (12), the first cathode (12) being made of a first material;
a first arc power supply (14) for powering the first cathode (12), the first arc power supply (14) being configured to be operated in pulsed mode, the vacuum chamber (4) being configured to ignite an arc between the at least one anode (10, 20, 30) and the first cathode (12) by a pulsed first cathode arc discharge (16);
a second cathode (22), the second cathode (22) being made of a second material being different to the first material;
a second arc power supply (24) for powering the second cathode (22), the second arc power supply (24) being configured to be operated in pulsed mode, the vacuum chamber (4) being configured to ignite an arc between the at least one anode (10, 20, 30) and the second cathode (22) by a pulsed second cathode arc discharge (26); and
substrate holding means (8) for holding at least one substrate (6) to be coated so as to be arranged in the vacuum chamber (4); and
a bias voltage supply (40) for powering the at least one substrate (6) when being arranged in the vacuum chamber (4), the bias voltage supply (40) being configured to be operated in pulsed mode;
**characterized in that**
the cathodic arc evaporation apparatus (2) is configured in such a way that the pulsed first cathode arc discharge (16) and the pulsed second cathode arc discharge (26) are time-shifted relative to each other and in synchronization with a pulsed bias voltage (42) such that the pulsed first cathode arc discharge (16) and the pulsed second cathode arc discharge (26) are offset from each other within a pulse period of the pulsed bias voltage (42) and at the same time within each pulse period of the pulsed bias voltage (42).

2. The cathodic arc evaporation apparatus (2) according to claim 1,
wherein the cathodic arc evaporation apparatus (2) is configured in such a way that the pulsed bias voltage (42) is different during the pulsed first cathode arc discharge (16) and the pulsed second cathode arc discharge (26).

3. The cathodic arc evaporation apparatus (2) according to claim 2,
wherein the cathodic arc evaporation apparatus (2) is configured in such a way that a maximum amplitude/peak of the pulsed bias voltage (42) is at least partially overlapping with a maximum amplitude/peak of the pulsed first cathode arc discharge (16) and/or the pulsed second cathode arc discharge (26).

4. The cathodic arc evaporation apparatus (2) according to claim 3,
wherein the cathodic arc evaporation apparatus (2) is configured in such a way that the maximum amplitude/peak of the pulsed bias voltage (42) takes place at the same time as the maximum amplitude/peak of the pulsed first cathode arc discharge (16) or the pulsed second cathode arc discharge (26).

5. The cathodic arc evaporation apparatus (2) according to claim 3 or 4,
wherein the cathodic arc evaporation apparatus (2) is configured in such a way that an amplitude of the pulsed bias voltage (42) being lower than the maximum amplitude/peak of the pulsed bias voltage (42) takes place at the same time as the maximum amplitude/peak of the pulsed first cathode arc discharge (16) or the pulsed second cathode arc discharge (26).

6. The cathodic arc evaporation apparatus (2) according to any one of claims 3 to 5, wherein the cathodic arc evaporation apparatus (2) is configured in such a way that a duration of the maximum amplitude/peak of the pulsed first cathode arc discharge (16) is different to a duration the maximum amplitude/peak of the pulsed second cathode arc discharge (26).

7. The cathodic arc evaporation apparatus (2) according to any one of claims 1 to 6, wherein the cathodic arc evaporation apparatus (2) is configured in such a way that a pulse frequency of the pulsed first cathode arc discharge (16), the pulsed second cathode arc discharge (26) and/or the pulsed bias voltage (42) are/is lower than 50 Hz, preferably lower than 20 Hz, for example about 10 Hz.

8. The cathodic arc evaporation apparatus (2) according to claim 7,
wherein the substrate holding means (8) are configured in such a way that the at least one substrate (6) is rotatable with a predetermined rotational speed and/or the first and second cathodes (12, 22) are rotatable with a predetermined rotational speed,
wherein the cathodic arc evaporation apparatus (2) is configured in such a way that the pulse frequency is set in accordance with the predetermined rotational speed.

9. The cathodic arc evaporation apparatus according to any one of claims 1 to 8, wherein the vacuum chamber (4) comprises a third cathode (32), the third cathode (32) being made of a third material being different than the first material and the second material, and a third arc power supply (34) for powering the third cathode (32), the third arc power supply (34) being configured to be operated in pulsed mode, the vacuum chamber (4) being configured to ignite an arc between the at least one anode (10, 20, 30) and third cathode (32) by a third cathode pulsed arc discharge (36),
wherein the cathodic arc evaporation apparatus (2) is configured in such a way that the pulsed first cathode arc discharge (16), the pulsed second cathode arc discharge (26) and the third cathode pulsed arc discharge (36) are time-shifted relative to each other and are in synchronization with the pulsed bias voltage (42).

10. A cathodic arc evaporation method for coating at least one substrate (6) in a vacuum chamber (4) comprising at least one anode (10, 20, 30), a first cathode (12), and a second cathode (22), the first cathode (12) being made of a first material and the second cathode (22) being made of a second material different to the first material, the method comprising:
powering the first cathode (12) in a pulsed mode and igniting an arc between the at least one anode (10, 20, 30) and the first cathode (12) by a pulsed first cathode arc discharge (16),
powering the second cathode (22) in a pulsed mode and igniting an arc between the at least one anode (10, 20, 30) and the second cathode (22) by a pulsed second cathode arc discharge (26), and
powering the at least one substrate (6) in a pulsed mode,
**characterized in that**
the pulsed first cathode arc discharge (16) and the pulsed second cathode arc discharge (26) are time-shifted relative to each other and are in synchronization with a pulsed bias voltage (42) such that the pulsed first cathode arc discharge (16) and the pulsed second cathode arc discharge (26) are offset from each other within a pulse period of the pulsed bias voltage (42) and at the same time within each pulse period of the pulsed bias voltage (42).
